(19) Europäisches Patentamt / European Patent Office / Office européen des brevets

(11) **EP 1 771 798 B1**

(12) **EUROPÄISCHE PATENTSCHRIFT**

(45) Veröffentlichungstag und Bekanntmachung des Hinweises auf die Patenterteilung:
**10.06.2009 Patentblatt 2009/24**

(21) Anmeldenummer: **05771365.3**

(22) Anmeldetag: **28.07.2005**

(51) Int Cl.:
*G06F 17/50* (2006.01)

(86) Internationale Anmeldenummer:
**PCT/DE2005/001340**

(87) Internationale Veröffentlichungsnummer:
**WO 2006/012867 (09.02.2006 Gazette 2006/06)**

(54) **VERFAHREN DER BEWERTUNG DER GÜTE EINES COMPUTERPROGRAMMS**

METHOD FOR EVALUATING THE QUALITY OF A COMPUTER PROGRAMM

PROCEDE D'EVALUATION DE LA QUALITE D'UN PROGRAMME INFORMATIQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **30.07.2004 DE 102004037403**

(43) Veröffentlichungstag der Anmeldung:
**11.04.2007 Patentblatt 2007/15**

(73) Patentinhaber: **Certess S.A.**
**38340 Voreppe (FR)**

(72) Erfinder:
• **GROSSE, Jörg**
**01099 Dresden (DE)**
• **HAMPTON, Mark**
**38260 La Côte-Saint-André (FR)**

(74) Vertreter: **Carlsohn, Alexander**
**Patentanwälte**
**Riechelmann & Carlsohn**
**Wiener Strasse 91**
**01219 Dresden (DE)**

(56) Entgegenhaltungen:
**DE-A1- 19 959 157        US-B1- 6 473 726**

• **JEFFERSON OFFUTT A: "INVESTIGATIONS OF THE SOFTWARE TESTING COUPLING EFFECT" ACM TRANSACTIONS ON SOFTWARE ENGINEERING AND METHODOLOGY, ASSOCIATION FOR COMPUTING MACHINERY, NEW YORK, US, Bd. 1, Nr. 1, Januar 1992 (1992-01), Seiten 5-20, XP000365048 ISSN: 1049-331X**
• **KING K N ET AL: "A FORTRAN LANGUAGE SYSTEM FOR MUTATIONBASED SOFTWARE TESTING*" SOFTWARE PRACTICE & EXPERIENCE, WILEY & SONS, BOGNOR REGIS, GB, Bd. 21, Nr. 7, 1. Juli 1991 (1991-07-01), Seiten 685-718, XP000297324 ISSN: 0038-0644**
• **VADO P ET AL: "A methodology for validating digital circuits with mutation testing" CIRCUITS AND SYSTEMS, 2000. PROCEEDINGS. ISCAS 2000 GENEVA. THE 2000 IEEE INTERNATIONAL SYMPOSIUM ON MAY 28-31, 2000, PISCATAWAY, NJ, USA,IEEE, Bd. 1, Mai 2000 (2000-05), Seiten I343-I346, XP010503205 ISBN: 0-7803-5482-6**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Bewertung der Güte eines Computerprogramms sowie dessen Verwendung bei der Verifizierung einer integrierten Schaltung oder eines Entwurfes einer integrierten Schaltung.

Die Größe und Komplexität von Computerprogrammen nimmt ständig zu. Damit ist jedoch auch die Zunahme von Fehlern verbunden.

In der Regel werden integrierte Schaltungen mittels spezieller Computersprachen, sogenannten High Level Description Languages (HDLs), beschrieben. Übliche HDLs sind VHDL und Verilog. Der HDL-File wird verwendet, um mittels spezieller Computerprogramme automatisch das Layout der Schaltungsanordnung und die erforderlichen photolithographischen Masken zu erzeugen, mit denen die tatsächliche Schaltungsanordnung hergestellt werden kann.

Zur Vermeidung von Fehlern in den integrierten Schaltungen kann es jedoch erforderlich sein, die mittels des HDL-Files beschriebenen Schaltungsanordnungen zu testen. Zu diesem Zwecke werden Programme verwendet, die auf Grundlage des HDL-Files die integrierte Schaltung simulieren. Derartige Programme werden als Simulatoren bezeichnet. Ein solcher Simulator wirkt mit einem als Prüfbank ("Test-Bench") bezeichneten Computerprogramm (d. h. Computercode) zusammen, das die Eingangsdaten ("Input") bereitstellt, die die integrierte Schaltung verarbeiten soll, und die Ergebnisse der Verarbeitung in der simulierten Schaltung mit den erwarteten Ergebnissen vergleicht. Das Computerprogramm beschreibt also (1) die Ein-Eingangsdaten (ggf. im Form von Signalwellenformen), (2) die Leistungs- und Richtigkeitskriterien, die nach der Verarbeitung der Eingangsdaten in der simulierten Schaltung erhalten werden, und (3) die Handlungen, die der Simulator ausführen soll, wenn die Ergebnisse der Simulation den Leistungs- und Richtigkeitskriterien entsprechen oder wenn dies nicht der Fall ist.

Das Testergebnis hängt allerdings wesentlich von der Qualität und der Vollständigkeit des Computerprogramms ab. Im Hinblick auf die hohe Zahl elektronischer Komponenten, die in dem HDL-File beschrieben werden, ist es sehr schwierig, Computerprogramme zu schaffen, die der Komplexität der zu testenden simulierten integrierten Schaltung gerecht werden. Fehler in der simulierten Schaltung können nur dann gefunden werden, wenn das Computerprogramm tatsächlich Tests vorsieht, die den fehlerhaften Bereich der simulierten integrierten Schaltung betreffen. Anderenfalls kann ein positives Testergebnis unter Umständen lediglich auf eine unzureichende Testung (bzw. Verifizierung) der integrierten Schaltung zurückzuführen sein. Eine Überprüfung der Qualität und der Vollständigkeit des Computerprogramms ist daher erforderlich. Die ohnehin geringe Geschwindigkeit der Softwaresimulation einer integrierten Schaltung wird durch Tests, die die Qualität und die Vollständigkeit des Computerprogramms überprüfen sollen, allerdings weiter verringert.

DE 199 59 157 A1 beschreibt ein System zum funktionsmäßigen Simulieren und Überprüfen der Korrektheit eines Computerprogramms, bei dem mutationsbehaftete Computerprogramme erzeugt werden. Das Computerprogramm kann Quellcodemodule aus Funktionsmodellen einer integrierten Schaltung aufweisen.

US 6,473,726 B1 offenbart ein Verfahren zur gleichzeitigen Emulation von mehreren Schaltungsdesigns auf einem Emulationssystem.

Aufgabe der Erfindung ist es, die Nachteile nach dem Stand der Technik zu beseitigen. Insbesondere soll ein Verfahren angegeben werden, daß die Bewertung der Güte eines Computerprogramms mit erheblich höherer Geschwindigkeit ermöglicht.

Diese Aufgabe wird durch die Merkmale von Anspruch 1 gelöst. Zweckmäßige Ausgestaltungen der Erfindungen ergeben sich aus den Merkmalen der Ansprüche 2 bis 7.

Nach Maßgabe der Erfindung ist ein Verfahren zur Bewertung der Güte eines Computerprogramms gemäß dem anhängenden Patentanspruch 1 vorgesehen, bei dessen Ausführung die Eingangsdaten und die Ausgangsdaten einer integrierten Schaltung beeinflußt werden, umfassend

(a) das Bereitstellen einer mutierten integrierten Schaltung, die durch Einbau einer oder mehrerer funktioneller Mutationen in die (unmutierte) integrierte Schaltung erhalten wird;

(b) das Beeinflussen der Eingangsdaten und der Ausgangsdaten der mutierten integrierten Schaltung, wobei die Ausgangsdaten der mutierten integrierten Schaltung erfaßt werden;

(c) den Vergleich der so erhaltenen Ausgangsdaten der mutierten integrierten Schaltung mit den Ausgangsdaten, die bei Beeinflussung der unmutierten integrierten Schaltung durch das Computerprogramm erwartet werden; und

(d) Bewertung der Güte des Computerprogramms anhand der Vergleichsergebnisse, entsprechend den Definitionen von Anspruch 1.

Zweckmäßigerweise werden in Schritt (a) die funktionellen Mutationen in der Datei vorgenommen, die die (unmutierte) integrierten Schaltung beschreibt. Die so erhaltene mutierte Datei kann dann zur Herstellung der mutierten integrierten Schaltung verwendet werden. Es ist also nicht erforderlich, die (unmutierten) integrierte Schaltung selbst herzustellen. Zur Ausführung des erfindungsgemäßen Verfahrens ist es vielmehr ausreichend, wenn die mutierte Schaltung tatsächlich hergestellt wird.

Das Computerprogramm kann eine Prüfbank für eine integrierte Schaltung oder für den Entwurf einer integrierten Schaltung umfassen. In diesem Fall kann das Verfahren bei der Verifizierung einer integrierten Schaltung bzw. des Entwurfes einer integrierten Schaltung verwendet werden.

Das Verfahren kann im Vergleich zum Stand der Technik, das die Softwaresimulierung der integrierten Schaltung erfordert, mit hoher Geschwindigkeit ausgeführt werden.

Die mutierte integrierte Schaltung wird auf einer oder mehreren feldprogrammierbaren Gateanordnungen (FPGA) realisiert.

Unter funktionellen Mutationen werden hier Mutationen verstanden, die in die RTL-Ebene (RTL = Register Transfer Level) oder eine höhere Ebene (Systemebene oder algorithmische Ebene) eines Entwurfes einer integrierten Schaltung oder der integrierten Schaltung selbst eingebaut werden. Eine Mutation ist eine gewollte Veränderung der integrierten Schaltung gegenüber der unmutierten integrierten Schaltung. Geeignete Mutationstypen sind beispielsweise logische Negationsfehler, Auslassen logischer Faktoren, unkorrekte logische Faktoren, Auslassungen von logischen Ausdrücken, unkorrekte logische Ausdrücke, unkorrekte numerische Werte und Fallauslassungen.

Die Erfindung wird nachstehend anhand von Zeichnungen näher erläutert. Dabei zeigt

Fig. 1    ein Flußdiagramm zur Veranschaulichung des Schrittes (a) des erfindungsgemäßen Verfahrens;

Fig. 2    den HDL-File einer beispielhaften unmutierten integrierten Schaltung;

Fig. 3    den HDL'-File der in Fig. 2 gezeigten mutierten integrierten Schaltung;

Fig. 4    eine Darstellung der synthetisierten integrierten Schaltung von Fig. 3;

Fig. 5    eine schematische Darstellung einer ersten Ausführungsform des erfindungsgemäßen Verfahrens und

Fig. 6    eine schematische Darstellung einer zweiten Ausführungsform des erfindungsgemäßen Verfahrens.

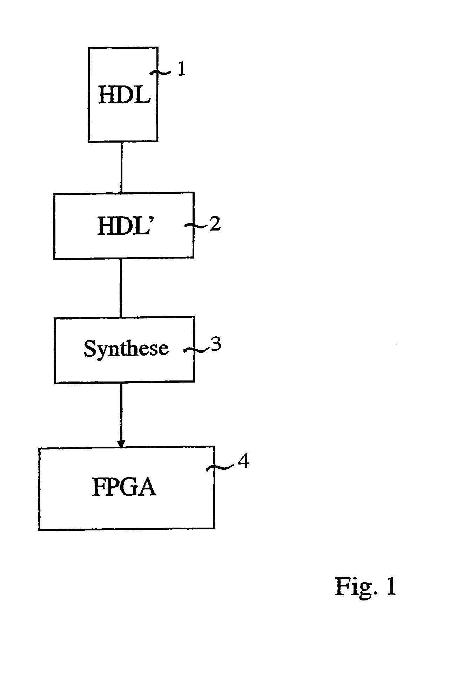

Fig. 1 veranschaulicht Schritt (a) des erfindungsgemäßen Verfahrens. Schritt (a) umfaßt demnach das Bereitstellen einer Datei, die den Code einer integrierten Schaltung umfaßt, beispielsweise eines HDL-Files 1. In diesem HDL-File 1 werden eine oder mehrere funktionelle Mutationen eingebaut, wodurch eine mutierter HDL-File, HDL'-File 2, erhalten wird. Der HDL'-File 2 kann mehrere funktionelle Mutationen enthalten, wobei jeweils nur eine dieser Mutationen nach der Realisierung der mutierten Schaltung auf einem oder mehreren FPGAs aktiv geschaltet wird.

Die funktionellen Mutationen können von einer Mutationserzeugungseinrichtung bereitgestellt und dabei aus einem vordefinierten Satz von Mutationstypen ausgewählt werden. Die Anzahl, Art und Reihenfolge der Mutationen hängt von der Komplexität und dem Zweck der konkreten integrierten Schaltung ab.

Anschließend wird die mutierte integrierte Schaltung auf Basis des mutierten HDL'-Files 2 synthetisiert (Synthese 3) und die mutierte Schaltung auf einem FPGA realisiert.

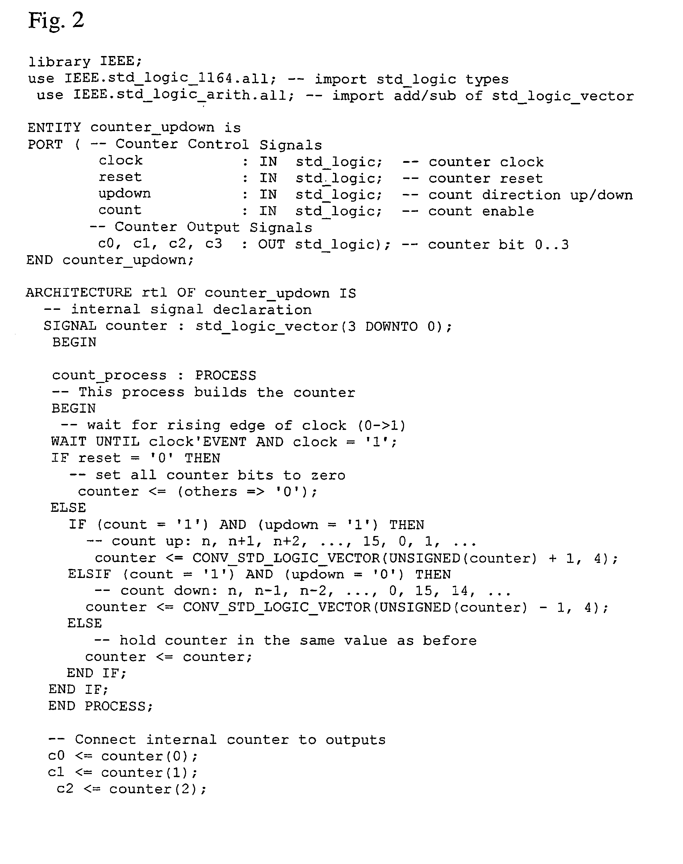

Der in Fig. 2 dargestellte HDL-File enthält den vollständigen HDL-Code für einen 4-Bit-Vorwärts/Rückwärts-Zähler, der die Datenausgänge C0, C1, C2 und C3 aufweist und von 0 bis 15 oder in entgegengesetzter Richtung zählt. Er umfaßt folgende Dateneingänge:

Reset:    der Zähler wird bei Reset = 0 auf den Wert 0 zurückgesetzt, wenn eine steigende Clock-Flanke vorliegt (d. h. Clock von 0 auf 1 geht);

Clock:    Takteingang - steigende Flanke (auch als "Clock-Flanke" bezeichnet)

UpDown:    der Zähler addiert bei UpDown = 1; er subtrahiert bei UpDown = 0

Count:    der Wert des Zählers wird mit der steigenden Clock-Flanke um eins erhöht, wenn Count = 1, Reset = 1 und UpDown = 1; der Wert des Zählers wird mit der steigenden Clock-Flanke um eins verringert, wenn Count = 1, Reset = 1 und UpDown = 0; der Wert des Zählers wird nicht verändert, wenn Count = 0 und Reset = 1.

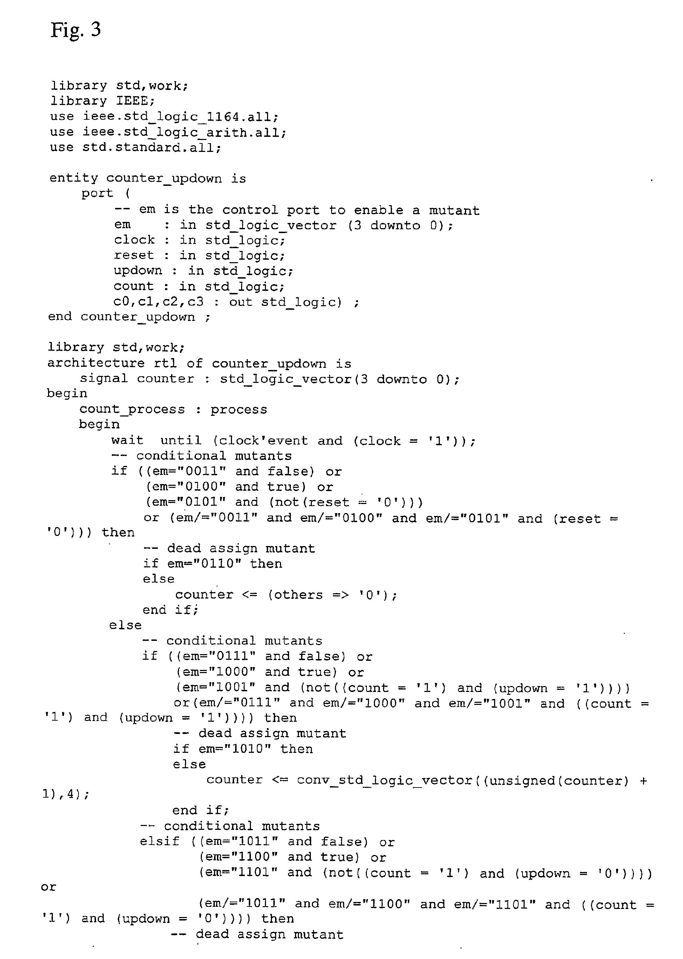

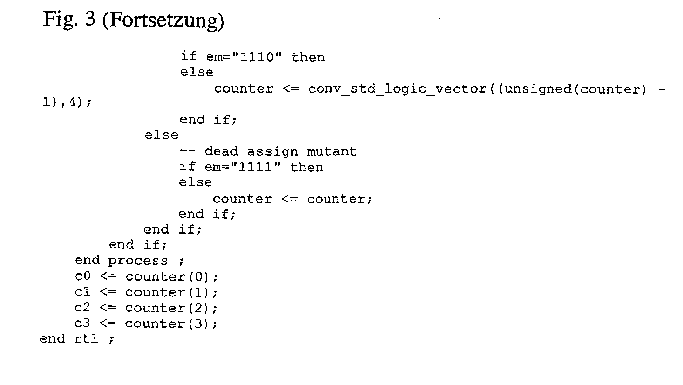

Der in Fig. 3 dargestellte HDL'-File enthält Mutationen, die in den in Fig. 2 dargestellten HDL-File eingefügt worden sind. Der HDL'-Code beschreibt einen 4-Bit-Vorwärts/Rückwärts-Zähler, der die Datenausgänge C0, C1, C2 und C3 aufweist und von 0 bis 15 oder in entgegengesetzter Richtung zählt. Er umfaßt folgende Dateneingänge:

Reset:    der Zähler wird bei Reset = 0 auf den Wert 0 zurückgesetzt, wenn eine steigende Clock-Flanke vorliegt (d. h. Clock von 0 auf 1 geht);

Clock:    Takteingang - steigende Flanke

UpDown:    der Zähler addiert bei UpDown = 1; er subtrahiert bei UpDown = 0

Count:    der Wert des Zählers wird mit der steigenden Clock-Flanke um eins erhöht, wenn Count = 1, Reset = 1 und UpDown = 1; der Wert des Zählers wird mit der steigenden Clock-Flanke um eins verringert, wenn Count = 1, Reset = 1 und UpDown = 0; der Wert des Zählers wird nicht verändert, wenn Count = 0 und Reset = 1.

Em ermöglicht es, eine Mutation $em_i$ der in den HDL'-File eingefügten Mutationen $em_n$ (n 1 bis 13) aktiv zu schalten, während alle anderen Mutationen inaktiv geschaltet sind.

Die einzelnen funktionellen Mutationen sind in dem HDL'-File 2 binär als em = "0011" ($em_1$), em = 2"0100" ($em_2$) ... em = "1110" ($em_{13}$) codiert.

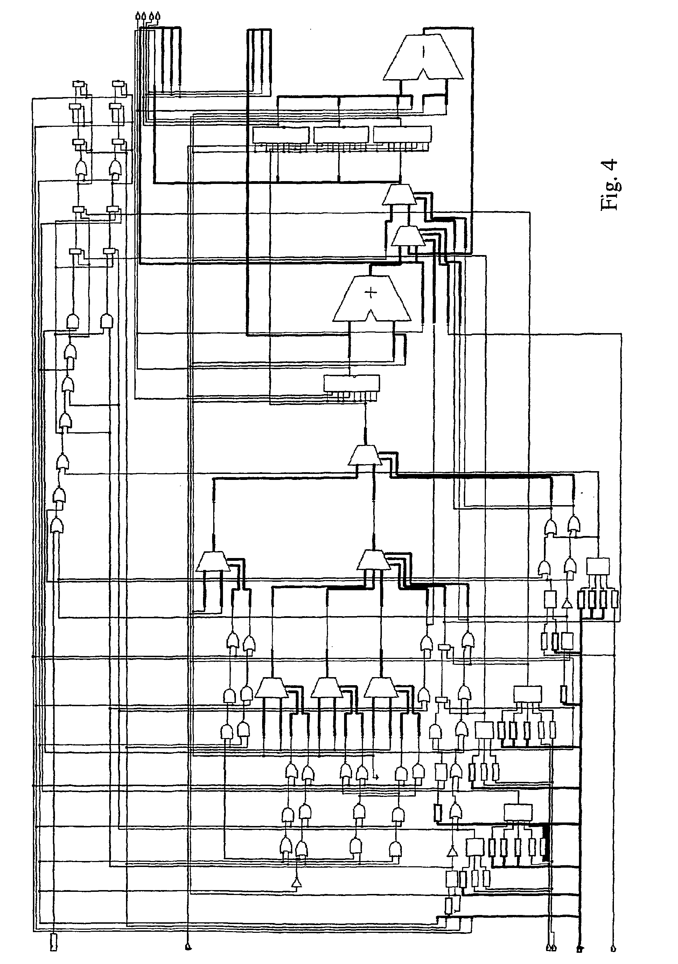

Fig. 4 zeigt das Schaltbild einer gemäß dem HDL'-File 2 synthetisierten, mutierten Schaltung.

Nachdem auf diese Weise eine mutierten integrierte Schaltung auf dem FPGA realisiert wurden ist (Schritt (a) des erfindungsgemäßen Verfahrens), werden die Dateneingänge der mutierten Schaltung von einem Testprogramm, das auf einem Computer ausgeführt wird, mit Eingangsdaten beaufschlagt und die an den Datenausgängen der mutierten integrierten Schaltung erhaltenen Ausgangsdaten erfaßt (Schritt (b) des erfindungsgemäßen Verfahrens).

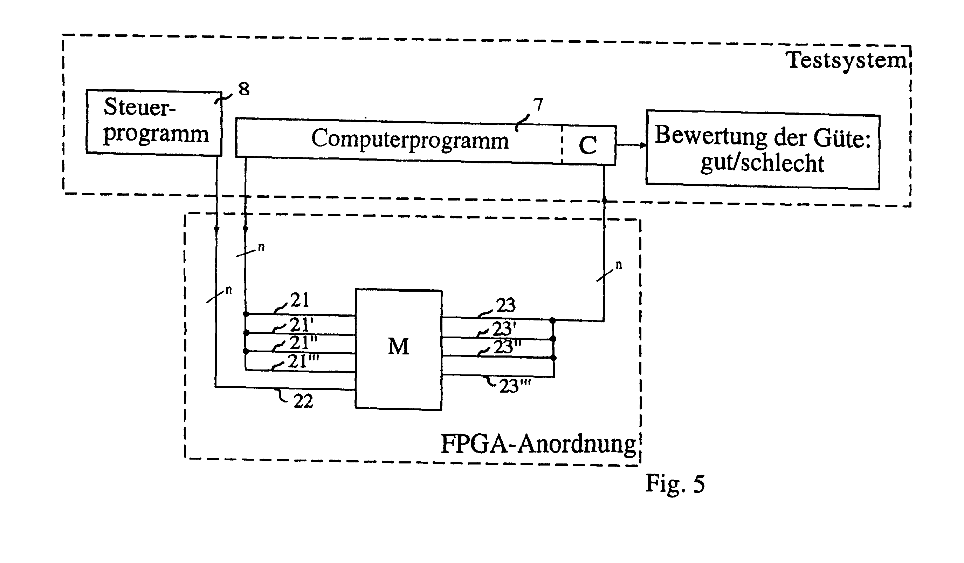

Eine erste Möglichkeit zur Ausführung des Schrittes (c) des erfindungsgemäßen Verfahrens auf Basis der in Fig. 3 gezeigten mutierten integrierten Schaltung, die auf einem FPGA realisiert wurde, wird in Fig. 5 veranschaulicht. In Fig. 5 ist die mutierte Schaltung mit "M" gekennzeichnet; die mutierte Schaltung umfaßt die Dateneingänge 21 (Reset), 21' (Clock), 21" (UpDown), 21''' (Count) sowie den zusätzlichen Dateneingang 22, der dem Dateneingang Em (siehe Fig. 3) entspricht. SP kennzeichnet das Steuerprogramm, das die in die Schaltung eingebauten Mutationen $em_n$ über den Dateneingang Em aktiv bzw. inaktiv schaltet.

Die mutierte Schaltung M wird mit Eingangsdaten über die Eingangsports beaufschlagt, wobei die Eingangsdaten von dem Computerprogramm 7 bereitgestellt werden. Die Ausgangsdaten 23 der mutierten Schaltung M werden dem Computerprogramm 7 zugeführt und dort (mit dem Buchstaben "C" gekennzeichnet) mit den Werten (Erwartungswerten) verglichen, die bei einer unmutierten Schaltung vom Computerprogramm erwartet würden. Dabei wird folgendes Vergleichsergebnis erhalten: Entsprechen die Ausgangsdaten 24 den Erwartungswerten, so hat die aktiv geschaltete Mutation keinen Einfluß auf die Verarbeitung der Eingangsdaten in der mutierten Schaltung gehabt. Unterscheiden sich die Ausgangsdaten 24 von den Erwartungswerten, so hat die aktiv geschaltete Mutation die Verarbeitung der Eingangsdaten in der mutierten Schaltung verändert.

Ist keine Mutation aktiv geschaltet, so verhält sich die mutierte integrierte Schaltung wie die ihr zugrundliegende unmutierte Schaltung.

Die mutierte integrierte Schaltung M ist auf einem oder mehreren FPGA (FPGA-Anordnung) realisiert.

Dies ist in Fig. 5 durch den mit "FPGA-Anordnung" bezeichneten gestrichelten Kasten verdeutlicht. Das Steuerprogramm 8, das Computerprogramm, das die Untereinheit C umfaßt, sowie die Bewertung der Güte des Computerprogrammes werden auf einem herkömmlichen Computer realisiert. Der Computer wird durch den mit "Testsystem" bezeichneten gestrichelten Kasten verdeutlicht.

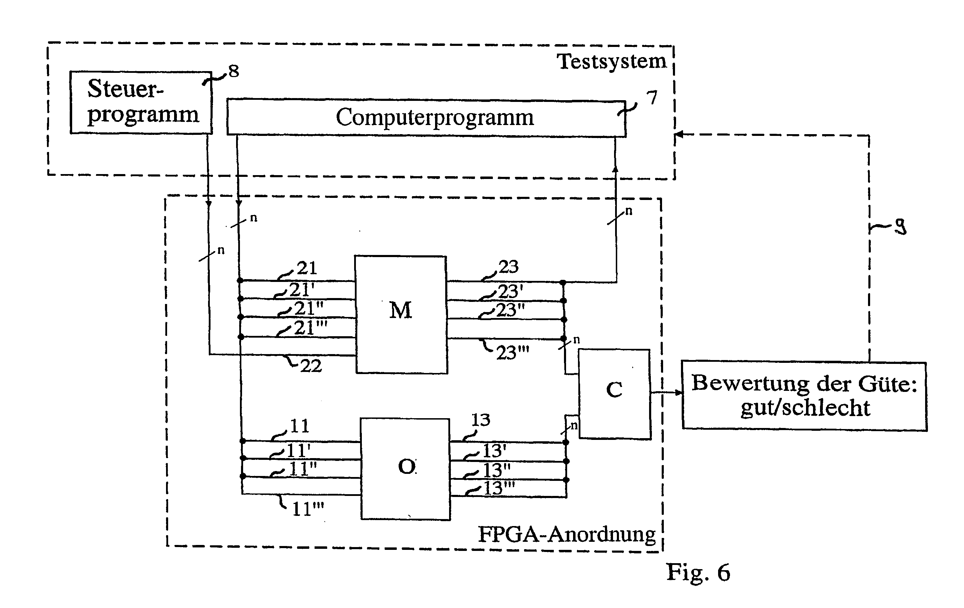

Eine zweite Möglichkeit zur Ausführung des Schrittes (c) des erfindungsgemäßen Verfahrens auf Basis des in Fig. 3 gezeigten mutierten HDL'-Files wird in Fig. 6 veranschaulicht. In Fig. 5 ist die mutierte Schaltung mit "M" gekennzeichnet, die unmutierte Schaltung mit "O". Sowohl die mutierte Schaltung M als auch die unmutierte Schaltung O sind jeweils auf einem FPGA ausgebildet. Die unmutierte Schaltung umfaßt die Dateneingänge 11, 11', 11" sowie 11'''. Die mutierte Schaltung umfaßt die Dateneingänge 21, 21', 21'', 21''' sowie den zusätzlichen Dateneingang 22, der dem Dateneingang em (siehe Fig. 3) entspricht. Das Steuerprogramm schaltet die in die mutierte integrierte Schaltung eingebauten Mutationen über den Dateneingang em aktiv bzw. inaktiv.

Die unmutierte Schaltung O und die mutierte Schaltung M werden mit denselben Eingangsdaten über die Eingangsports beaufschlagt, wobei die Eingangsdaten von dem Computerprogramm 7 bereitgestellt werden. Die Ausgangsdaten 13, 13', 13'' und 13''' der unmutierten Schaltung O und die Ausgangsdaten 23, 23', 23'', 23''' der mutierten Schaltung M werden einem Comparator C (Vergleicher) zugeführt und miteinander verglichen, wobei folgendes Vergleichsergebnis erhalten wird: Entsprechen die Ausgangsdaten 13, 13', 13'' und 13''' den Ausgangsdaten 23, 23', 23'', 23''', so hat die aktiv geschaltete Mutation keinen Einfluß auf die Verarbeitung der Eingangsdaten in der mutierten Schaltung gehabt. Unterscheiden sich die Ausgangsdaten 13, 13', 13" und 13''' von den Ausgangsdaten 23, 23', 23", 23''', so hat die aktiv geschaltete Mutation die Verarbeitung der Eingangsdaten in der mutierten Schaltung verändert.

Die mutierte integrierte Schaltung M, die unmutierte integrierte Schaltung O und der Comparator C sind auf einem oder mehreren FPGA gemeinsam oder getrennt voneinander realisiert. Dies ist in Fig. 5 durch den mit "FPGA-Anordnung" bezeichneten gestrichelten Kasten verdeutlicht. Das Steuerprogramm 8 und das Computerprogramm 7 sind auf einem herkömmlichen Computer realisiert. Der Computer durch den mit "Testsystem" bezeichneten gestrichelten Kasten verdeutlicht. Die Auswertung der vom Comparator C erhaltenen Ergebnisse, d. h. die Bewertung der Güte, kann von einem Programm, das Bestandteil des Testsystems ist, beispielsweise auch vom Computerprogramms 7 vorgenommen werden (Pfeil 9).

Die Eingangsdaten werden von einem Computerprogramm bereitgestellt. Wenn es sich bei diesem Computerprogramm um eine Prüfbank, d. h. ein Programm handelt, mit dem eine integrierte Schaltung auf Fehler getestet werden soll, so kann aus dem Vergleichsergebnis folgendes gefolgert werden: Eine aktiv geschaltete Mutation sollte die Ausgangsdaten einer integrierten Schaltung verändern. Wenn die aktiv geschaltete Mutation die Ausgangsdaten im Vergleich zur unmutierten Schaltung jedoch nicht verändert, so hatte sie keinen Einfluß auf die Verarbeitung der Eingangsdaten in der mutierten Schaltung. In diesem Fall ist diese Mutation bei der Testung der integrierten Schaltung durch die Testsoftware, insbesondere die Prüfbank, nicht erkannt worden, so daß die Testsoftware mangelhaft ist. Die Güte dieses Computerprogramms ist somit schlecht.

Wenn die aktiv geschaltete Mutation die Ausgangsdaten im Vergleich zur unmutierten Schaltung jedoch veränderte, so hatte sie Einfluß auf die Verarbeitung der Eingangsdaten in der mutierten Schaltung. In diesem Fall ist diese Mutation bei der Testung der integrierten Schaltung durch die Testsoftware, insbesondere die Prüfbank, erkannt worden, so daß die Testsoftware diesen Bereich der Schaltung tatsächlich testet. Die Güte dieses Computerprogramms ist in bezug auf diese aktiv geschaltete Mutation somit gut.

Die Mutationen, die die Ausgangsdaten der mutierten integrierten Schaltung M im Vergleich zu unmutierten Schaltungen veränderten, können als detektierte Mutationen bezeichnet werden. Die Mutationen, die die Ausgangsdaten der mutierten integrierten Schaltung M im Vergleich zu unmutierten Schaltungen nicht veränderten, können als detektierte Mutationen bezeichnet werden. Dann kann die Güte G des Computerprogrammes aus dem Verhältnis der Anzahl detektierter Mutionen $N_{dM}$ zu der Gesamtzahl an Mutationen $N_M$ gemäß der folgenden Gleich berechnet werden.

$$G = \frac{N_{dM}}{N_M}$$

Die Güte des Computerprogramms ist somit um so höher, je höher die Zahl der detektierten Mutationen ist. Werden beispielsweise von dem in Fig. 3 dargestellten Mutationen sechs detektiert, weil sich die Ausgangsdaten, die mit diesen Mutationen erhalten werden, von den Erwartungswerten unterscheiden, so wird bei einer Gesamtzahl von 13 Mutationen, eine Werte für die Güte des Computerprogramms von 0,46 erhalten. In diesem Fall kann die Güte des Computerprogramms als "schlecht" bezeichnet werden. Werden dagegen 13 der 13 Mutationen detektiert, so wird für die Güte eine Wert von 1,00 erhalten. In diesem Fall kann die Güte des Computerprogramms als "gut" bezeichnet werden. Allerdings ist dabei zu berücksichtigen, daß der genaue Zahlenwert, ab dem die Güte eines Computerprogramms als "gut" bezeichnet werden kann, von den Anforderungen anhängt, die an eine konkrete Schaltung und ein Computerprogramm für diese Schaltung gestellt werden.

Kann die Güte des Computerprogramms als "gut" bezeichnet werden, so ist dieses Computerprogramm, sofern es sich um ein Testprogramm für eine integrierte Schaltung oder für einen Entwurf einer integrierten Schaltung handelt, geeignet, zur Verifizierung der unmutierten Schaltung verwendet zu werden, da es dort ungewollte Mutationen erfassen kann. Muß die Güte des Computerprogramms jedoch als "schlecht" bezeichnet werden, so ist dieses Computerprogramm nicht geeignet, zur Verifizierung der unmutierten Schaltung verwendet zu werden, da es dort ungewollte Mutationen nicht erfassen oder nur unzureichend erfassen kann.

In der mutierten integrierten Schaltung ist jeweils eine Mutation aktiv geschaltet. Die Ausgangsdaten der mutierten integrierten Schaltung mit der ersten aktiv geschalteten Mutation $M_1$ (in Fig. 3 als $em_1$ bezeichnet) werden erfaßt. Anschließend wird Mutation $Mu_1$ inaktiv geschaltet und die folgende Mutation $Mu_2$ (in Fig. 3 als $em_2$ bezeichnet) aktiv geschaltet. Die Ausgangsdaten der mutierten integrierten Schaltung mit der zweiten aktiv geschalteten Mutation $Mu_2$ werden erfaßt. Diese Verfahrensweise wird für jede der Mutationen wiederholt, die in die mutierte integrierte Schaltung eingebaut worden sind. Die Reihenfolge der Aktivschaltung der Mutationen kann nach Zweckmäßigkeitserwägungen verändert werden.

## Patentansprüche

1. Verfahren zur Bewertung der Güte eines Computerprogramms, bei dessen Ausführung die Eingangsdaten und die Ausgangsdaten einer integrierten Schaltung beeinflußt werden, umfassend

    (a) das Bereitstellen einer mutierten integrierten Schaltung, die durch Einbau mehrerer funktioneller Mutationen in die unmutierte integrierte Schaltung erhalten wird, und das Realisieren der mutierten integrierten Schaltung mittels einer oder mehrerer feldprogrammierbarer Gateranordnungen (FPGA);
    (b) das Beeinflussen der Eingangsdaten und der Ausgangsdaten der mutierten integrierten Schaltung, wobei die Ausgangsdaten der mutierten integrierten Schaltung erfaßt werden;
    (c) den Vergleich der so erhaltenen Ausgangsdaten der mutierten integrierten Schaltung mit den Ausgangsdaten, die bei Beeinflussung der unmutierten integrierten Schaltung durch das Computerprogramm erwartet werden; und
    (d) Bewertung der Güte des Computerprogramms anhand der Vergleichsergebnisse;

    wobei jeweils eine der eingebauten Mutationen aktiv geschaltet ist, die anderen aber inaktiv geschaltet sind und die Schritte (b) bis (d) solange wiederholt werden, bis jede der eingebauten funktionellen Mutationen eine aktiv geschaltete Mutation gewesen ist; und wobei

die Güte des Computerprogramms anhand der Zahl der funktionellen Mutationen, die durch den in Schritt (c) durchgeführten Vergleich erkannt werden, im Verhältnis zu der Gesamtzahl der eingebauten Mutationen bestimmt wird.

2. Verfahren nach Anspruch 1, **dadurch gekennzeichnet, daß** das Computerprogramm ein Testprogramm für einen integrierten Schaltkreis oder den Entwurf eines integrierten Schaltkreis ist.

3. Verfahren nach einem der vorstehenden Ansprüche, **dadurch gekennzeichnet, daß** die Ausgangsdaten, die bei Beeinflussung der unmutierten integrierten Schaltung durch das Computerprogramm erwartet werden, in dem Computerprogramm gebildet werden.

4. Verfahren nach einem der Ansprüche 1 und 2, **dadurch gekennzeichnet, daß** Ausgangsdaten, die bei Beeinflussung der unmutierten integrierten Schaltung durch das Computerprogramm erwartet werden, die Ausgangsdaten sind, die bei Beeinflussung der unmutierten integrierten Schaltung durch das Computerprogramm erhalten werden.

5. Verfahren nach Anspruch 4, **dadurch gekennzeichnet, daß** die Ausgangsdaten, die bei Beeinflussung der unmutierten integrierten Schaltung durch das Computerprogramm erhalten werden, mit den Ausgangsdaten, die bei Beeinflussung der mutierten integrierten Schaltung durch das Computerprogramm erhalten werden, parallel zueinander ermittelt werden.

6. Verfahren nach einem der vorstehenden Ansprüche, **dadurch gekennzeichnet, daß** die Güte des Programms als "schlecht" bestimmt wird, wenn keine funktionelle Mutationen erkannt wird oder die Zahl der erkannten funktionellen Mutationen geringer als die Zahl der in Schritt (a) eingebauten funktionellen Mutationen ist.

7. Verfahren nach einem der vorstehenden Ansprüche, **dadurch gekennzeichnet, daß** die Güte des Programms als "gut" bestimmt wird, wenn alle eingebauten funktionellen Mutationen erkannt werden.

**Claims**

1. A method for rating the quality of a computer program whose execution involves an integrated circuit's input data and output data being influenced, comprising

    (a) provision of a mutated integrated circuit which is obtained by incorporating a plurality of functional mutations into the unmutated integrated circuit, and implementation of the mutated integrated circuit using one or more field programmable gate arrays (FPGA);

(b) influencing of the mutated integrated circuit's input data and output data, with the output data from the mutated integrated circuit being recorded;

(c) comparison of the output data obtained in this manner from the mutated integrated circuit with the output data which the computer program expects when the unmutated integrated circuit is influenced; and

(d) rating of the quality of the computer program on the basis of the comparison results.

where a respective one of the incorporated mutations is active but the others are inactive, and steps (b) to (d) are repeated until each of the incorporated functional mutations has been an activated mutation; and where

the quality of the computer program is determined from the number of functional mutations which are identified by the comparison performed in step (c) in relation to the total number of incorporated mutations.

2. The method as claimed in claim 1, wherein the computer program is a test program for an integrated circuit or the design of an integrated circuit.

3. The method as claimed in one of the preceding claims, wherein the output data which the computer program expects when the mutated integrated circuit is influenced are formed in the computer program.

4. The method as claimed in claim 1 or claim 2, wherein output data which the computer program expects when the unmutated integrated circuit is influenced are the output data which are obtained by the computer program when the unmutated integrated circuit is influenced.

5. The method as claimed in claim 4, wherein the output data which the computer program obtains when the unmutated integrated circuit is influenced and the output data which the computer program obtains when the mutated integrated circuit is influenced are ascertained in parallel with one another.

6. The method as claimed in one of the preceding claims, wherein the quality of the program is determined as "poor" if no functional mutations are identified or the number of functional mutations identified is lower than the number of functional mutations incorporated in step a).

**7.** The method as claimed in one of the preceding claims, wherein the quality of the program is determined as "good" if all the incorporated functional mutations are identified.

## Revendications

**1.** Processus d'évaluation de la qualité d'un programme informatique lors de l'exécution duquel les données d'entrée et les données de sortie d'un circuit intégré sont influencées, comprenant

    (a) la mise à disposition d'un circuit intégré muté obtenu par installation de plusieurs mutations fonctionnelles dans le circuit intégré non muté et la réalisation du circuit intégré muté à l'aide d'une ou plusieurs dispositions de circuits logiques programmables (LPGA) ;
    (b) l'influence des données d'entrée et des données de sortie du circuit intégré muté, les données de sortie du circuit intégré muté étant saisies ;
    (c) la comparaison des données de sortie du circuit intégré muté ainsi obtenues avec les données de sortie attendues lors de l'influence sur le circuit intégré non muté par le programme informatique ; et
    (d) évaluation de la qualité du programme informatique à l'aide des résultats comparatifs;

respectivement une des mutations installées étant activée, mais les autres étant désactivées et les opérations (b) à (d) étant répétées jusqu'à ce que chacune des mutations fonctionnelles installées soit une mutation activée ; et
la qualité du programme informatique étant déterminée à l'aide du nombre de mutations fonctionnelles, reconnues par la comparaison effectuée à l'opération (c), par rapport au nombre total des mutations installées.

**2.** Processus selon la revendication 1 **caractérisé en ce que** le programme informatique est un programme-test pour un circuit intégré ou le projet d'un circuit intégré.

**3.** Processus selon l'une des revendications mentionnées ci-dessus **caractérisé en ce que** les données de sortie attendues lors de l'influence sur le circuit intégré non muté par le programme informatique, sont formées dans le programme informatique.

**4.** Processus selon l'une des revendications 1 et 2 **caractérisé en ce que** les données de sortie attendue lors de l'influence sur le circuit intégré non muté par le programme informatique sont les données de sortie obtenues lors de l'influence sur le circuit intégré non muté par le programme informatique.

**5.** Processus selon la revendication 4 **caractérisée en ce que** les données de sortie obtenues lors de l'influence sur le circuit intégré non muté par le programme informatique, sont déterminées parallèlement entre elles avec les données de sortie obtenues par le programme informatique lors de l'influence sur le circuit intégré muté par le programme informatique.

**6.** Processus selon l'une des revendications mentionnées ci-dessus **caractérisé en ce que** la qualité du programme est déterminée comme étant "mauvaises" si aucune mutation fonctionnelle n'est reconnue ou si le nombre de mutations fonctionnelles reconnues est inférieur au nombre des mutations fonctionnelles installées à l'opération (a).

**7.** Processus selon l'une des revendications mentionnées ci-dessus **caractérisé en ce que** la qualité du programme est déterminée comme étant "bonne" si toutes les mutations fonctionnelles installées sont reconnues.

Fig. 1

# Fig. 2

```
library IEEE;
use IEEE.std_logic_1164.all; -- import std_logic types
 use IEEE.std_logic_arith.all; -- import add/sub of std_logic_vector

ENTITY counter_updown is
PORT ( -- Counter Control Signals
        clock          : IN  std_logic;  -- counter clock
        reset          : IN  std_logic;  -- counter reset
        updown         : IN  std_logic;  -- count direction up/down
        count          : IN  std_logic;  -- count enable
       -- Counter Output Signals
       c0, c1, c2, c3  : OUT std_logic); -- counter bit 0..3
END counter_updown;

ARCHITECTURE rtl OF counter_updown IS
  -- internal signal declaration
  SIGNAL counter : std_logic_vector(3 DOWNTO 0);
   BEGIN

   count_process : PROCESS
   -- This process builds the counter
   BEGIN
    -- wait for rising edge of clock (0->1)
   WAIT UNTIL clock'EVENT AND clock = '1';
   IF reset = '0' THEN
     -- set all counter bits to zero
      counter <= (others => '0');
   ELSE
     IF (count = '1') AND (updown = '1') THEN
       -- count up: n, n+1, n+2, ..., 15, 0, 1, ...
        counter <= CONV_STD_LOGIC_VECTOR(UNSIGNED(counter) + 1, 4);
     ELSIF (count = '1') AND (updown = '0') THEN
       -- count down: n, n-1, n-2, ..., 0, 15, 14, ...
        counter <= CONV_STD_LOGIC_VECTOR(UNSIGNED(counter) - 1, 4);
     ELSE
        -- hold counter in the same value as before
        counter <= counter;
     END IF;
   END IF;
   END PROCESS;

   -- Connect internal counter to outputs
   c0 <= counter(0);
   c1 <= counter(1);
    c2 <= counter(2);
```

# Fig. 3

```
library std,work;
library IEEE;
use ieee.std_logic_1164.all;
use ieee.std_logic_arith.all;
use std.standard.all;

entity counter_updown is
    port (
        -- em is the control port to enable a mutant
        em    : in std_logic_vector (3 downto 0);
        clock : in std_logic;
        reset : in std_logic;
        updown : in std_logic;
        count : in std_logic;
        c0,c1,c2,c3 : out std_logic) ;
end counter_updown ;

library std,work;
architecture rtl of counter_updown is
    signal counter : std_logic_vector(3 downto 0);
begin
    count_process : process
    begin
        wait  until (clock'event and (clock = '1'));
        -- conditional mutants
        if ((em="0011" and false) or
            (em="0100" and true) or
            (em="0101" and (not(reset = '0')))
            or (em/="0011" and em/="0100" and em/="0101" and (reset =
'0'))) then
            -- dead assign mutant
            if em="0110" then
            else
                counter <= (others => '0');
            end if;
        else
            -- conditional mutants
            if ((em="0111" and false) or
                (em="1000" and true) or
                (em="1001" and (not((count = '1') and (updown = '1')))))
                or(em/="0111" and em/="1000" and em/="1001" and ((count =
'1') and (updown = '1')))) then
                -- dead assign mutant
                if em="1010" then
                else
                    counter <= conv_std_logic_vector((unsigned(counter) +
1),4);
                end if;
            -- conditional mutants
            elsif ((em="1011" and false) or
                (em="1100" and true) or
                (em="1101" and (not((count = '1') and (updown = '0')))))
or
                (em/="1011" and em/="1100" and em/="1101" and ((count =
'1') and (updown = '0')))) then
                -- dead assign mutant
```

# Fig. 3 (Fortsetzung)

```
                if em="1110" then
                else
                    counter <= conv_std_logic_vector((unsigned(counter) -
1),4);
                end if;
            else
                -- dead assign mutant
                if em="1111" then
                else
                    counter <= counter;
                end if;
            end if;
        end if;
    end process ;
    c0 <= counter(0);
    c1 <= counter(1);
    c2 <= counter(2);
    c3 <= counter(3);
end rtl ;
```

Fig. 4

EP 1 771 798 B1

Fig. 5

Fig. 6

EP 1 771 798 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19959157 A1

- US 6473726 B1